# EUROPÄISCHE PATENTSCHRIFT

(11) **EP 2 024 528 B1**
(45) Veröffentlichungstag und Bekanntmachung des Hinweises auf die Patenterteilung: **01.06.2016**
(21) Anmeldenummer: 07724507.4
(22) Anmeldetag: 24.04.2007
(51) Int. Cl.: C04B 35/56, C23C 14/06, C23C 14/34, C23C 16/30, C23C 16/50, C04B 35/58

(54) **MULTIFUNKTIONELLE HARTSTOFFSCHICHTEN**
MULTIFUNCTIONAL HARD MATERIAL LAYERS
COUCHES DE MATIÈRES DURES MULTIFONCTIONNELLES

(30) Priorität: 28.04.2006 DE 102006019866
(43) Veröffentlichungstag der Anmeldung: 18.02.2009
(73) Patentinhaber: Karlsruher Institut für Technologie, 76131 Karlsruhe (DE)
(72) Erfinder: ULRICH, Sven, 76297 Stutensee-Blankenloch (DE); STÜBER, Michael, 76829 Landau (DE); LEISTE, Harald, 76356 Weingarten (DE); HOLLECK, Helmut, 76139 Karlsruhe (DE)
(86) Internationale Anmeldenummer: PCT/EP2007/003577
(87) Internationale Veröffentlichungsnummer: WO 2007/124890

(56) Entgegenhaltungen:
- WO-A-2006/005217
- JP-A- 62 207 869
- DING X ET AL: "Effect of oxygen incorporation on structural and properties of Ti-Si-N nanocomposite coatings deposited by reactive unbalanced magnetron sputtering" JOURNAL OF VACUUM SCIENCE AND TECHNOLOGY A. VACUUM, SURFACES AND FILMS, AMERICAN INSTITUTE OF PHYSICS, NEW YORK, NY, US, Bd. 24, Nr. 4, 22. Mai 2006 (2006-05-22), Seiten 974-977, XP012091161 ISSN: 0734-2101
- VEPREK S ET AL: "Degradation of superhard nanocomposites by built-in impurities" JOURNAL OF VACUUM SCIENCE & TECHNOLOGY B: MICROELECTRONICS PROCESSING AND PHENOMENA, AMERICAN VACUUM SOCIETY, NEW YORK, NY, US, Bd. 22, Nr. 2, März 2004 (2004-03), Seiten L5-L9, XP012074362 ISSN: 0734-211X
- SHTANSKY ET AL: "Multifunctional Ti-(Ca,Zr)-(C,N,O,P) films for load-bearing implants" BIOMATERIALS, ELSEVIER SCIENCE PUBLISHERS BV., BARKING, GB, Bd. 27, Nr. 19, 13. März 2006 (2006-03-13), Seiten 3519-3531, XP005365309 ISSN: 0142-9612
- E V Shalaeva ET AL: "Metastable phase diagram of Ti Si N(O) lms (C Si , 30 at.%)", Thin Solid Films, vol. 339, no. 1-2, 8 February 1999 (1999-02-08), pages 129-136, XP055107897, ISSN: 0040-6090, DOI: 10.1016/S0040-6090(98)01259-0

## Beschreibung

Die Erfindung betrifft eine Hartstoffbeschichtung gemäß des ersten sowie ein Verfahren zur Herstellung einer multifunktionellen Hartstoffbeschichtung auf einem Substrat gemäß des zehnten Patentanspruchs.

Hartstoffe werden in metallische, kovalente oder ionische Hartstoffe unterteilt. Jede dieser drei Hartstoffgruppen weisen spezifische Vor- und Nachteile auf. Die metallischen Hartstoffe wie beispielsweise die Übergangsmetallnitride und die Übergangsmetallkarbide besitzen von allen Hartstoffen in der Regel die höchste Zähigkeit und die beste Anbindung an metallische Substrate. Die kovalenten Hartstoffe wie z.B. Diamant, kubisches Bornitrid, Borkarbid, Siliziumkarbid oder Aluminiumnitrid zeichnen sich gegenüber allen anderen Hartstoffen durch ihre hohe Härte und Warmhärte aus. Die oxidischen Hartstoffe, zu denen auch Siliziumoxid gehört, haben die beste chemische Beständigkeit und die geringsten Oberflächenwechselwirkungstendenzen.

In E V Shalaeva et al., Thin Solids Films 339 (1999) S.129-136 werden eine Reihe von kubisch flächenzentrierten TiSiN(O)-Filmen auf einem Substrat beschrieben. Aus der Beugungsbildanalyse wurde angegeben, dass diese Filme auch ein einphasiges und kristallines Gefüge aufweisen können.

Davon ausgehend liegt die **Aufgabe der Erfindung** darin, eine einphasige und kristalline Hartstoffbeschichtung sowie ein Herstellverfahren derselben vorzuschlagen, die die Vorteile von metallischen und ionischen Hartstoffschichten in sich vereint.

Die Aufgabe wird durch eine Hartstoffbeschichtung und einem Herstellungsverfahren derselben mit den Merkmalen des ersten bzw. des achten Patentanspruchs gelöst. Die auf diese rückbezogene Unteransprüche geben vorteilhafte Ausgestaltungen wieder.

Der Grundgedanke der Erfindung liegt in einer Hartstoffbeschichtung auf einem Substrat, wobei die Hartstoffbeschichtung ein bevorzugt nanokristallines und einphasiges Gefüge bevorzugt mit mittleren Korngrößen unter 200 nm aufweist aus einem metastabilen Mischkristall aus zwei nicht miteinander lösbaren und damit im Prinzip nicht legierbaren Materialbestandteilen besteht. Die Materialbestandteile umfassen dabei einen metallischen und einen ionischen Hartstoff. Vorzugsweise bilden sich die Materialbestandteile aus dem quasibinären System aus einem kubisch flächenzentrierten Hartstoff und einer Oxidkeramik, wobei der kubisch flächenzentrierten Hartstoff weiter bevorzugt ein Karbid eines Übergangsmetalls ist und die Oxidkeramik auf Si oder Zr basiert.

Nur die Synthesebedingungen, in denen extrem hohe Abschreckraten (10¹³K/s) eingestellt werden können, wie dies mit PVD- und PECVD-Verfahren möglich ist, bilden sich solche Mischkristalle aus. Ist die Abschreckrate zu hoch, so bildet sich ein amorphes Netzwerk oder ein amorphes Netzwerk mit kristallinen Einschlüssen, und ist sie zu gering, so werden aufgrund der höheren Diffusionszeiten für die Atome/Moleküle verstärkt Komposite (Kristallgemische) hergestellt. Alle diese drei Modifikationen sind nicht Ziel dieser Erfindung. Gerade die Mischkristalle vereinen die positiven Eigenschaften der metallischen Hartstoffe wie Zähigkeit und gute Haftung auf Substraten mit denen der ionischen Hartstoffe wie chemische Beständigkeit und Hochtemperaturbeständigkeit insbesondere in sauerstoffhaltiger Umgebung.

Als Substratmaterialien eignen sich grundsätzlich alle Materialien, die Prozessschritte überstehen (Temperaturbelastung, Vakuum), wie z.B. Metall, Hartmetall, Cermets, Legierungen, Glas, Keramik oder bestimmten Polymere. Vor dem eigentlichen Beschichtungsprozess wird die Substratoberfläche bevorzugt durch Schleifen, Polieren und/oder Reinigen eines Substrats konfektioniert.

Die bevorzugten Schichtdicken liegen bevorzugt zwischen 1 und 10 µm und werden durch die Beschichtungszeit eingestellt.

Eine Idee liegt darin, eine Anzahl von Atomen der dominierenden Gitterstruktur eines Materialbestandteils durch Atome oder Molekülen eines anderen Materialbestandteils zu ersetzen. Beispielsweise nehmen Metallatome, insbesondere Silizium Si, Aluminium oder Zirkonium Zr in einem kubisch flächenzentrierten Gitter eines Karbids eines Übergangsmetalls wie Titan Ti, Niob Nb oder grundsätzlich auch ein anderes Element mit den Ordnungszahlen 21 bis 30, 39 bis 48 oder 57 bis 80 eine Anzahl von Gitterplätze ein, während eine Anzahl von Kohlenstoffatomen C auf ihren Gitterplätzen durch Sauerstoffatome O ersetzt werden.

Wesentlich ist die Synthese dieser nanokristallinen Mischkristalle. Mit einem bevorzugten reaktiven oder nicht reaktiven PVD-Verfahren (Physical Vapor Deposition) werden die einzelnen Materialbestandteile aus mindestens einem Materialreservoir gebildet.

Beim nicht reaktiven PVD-Verfahren werden die Materialbestandteile beispielsweise einer Sputterkathode pro Materialbestandteil simultan in die Gas- und/oder Plasmaphase überführt und kondensieren jeweils als Bestandteile einer Hartstoffschicht direkt auf einer Substratoberfläche ab.

Alternativ können im Rahmen eines reaktiven PVD-Verfahrens ein Teil der aus einer Kathode zerstäubten Elemente in einem Plasma mit einem Reaktivgas zu Molekülen reagieren.

In jedem Fall bilden unterschiedliche Materialbestandteile die sich als Elemente oder Moleküle in die damit metastabilen Mischkristalle einbauen. Dabei bildet sich bevorzugt eine sehr feinkörnige Struktur (Korngrößen unter 200 nm).

Durch die Abscheidung aus der Gasphase sind auf der Substratoberfläche extrem hohe Abschreckraten von bis zu 10¹³K/s erzielbar, was eine Bildung eines nanokristallinen Gefüges aus einem metastabilen Mischkristall mit Korngrenzen mit bevorzugten Korngrößen (Kristallitgrößen) unterhalb 1 µm, bevorzugt unter 200 nm, weiter bevorzugt zwischen 1 und 50 nm oder weiter bevorzugt 1 und 10 nm begünstigt. Die hohe Abschreckrate verhindert auch größere Diffusionsprozesse und damit eine ungewollte Entmischung im metastabilen Mischkristall im Mikromaßstab. Das Verfahren ist durch eine zusätzliche Temperierung des Substrats, bevorzugt über einen temperierbaren Substrathalter auf eine Temperatur zwischen 1 bis 1000°C, bevorzugt zwischen 20 und 700°C optimierbar.

Allgemein lassen sich besonders nanokristalline, Silizium-basierte, metastabile, multifunktionelle, oxidische Hartstoffschichten gezielt in ihren Eigenschaftsprofil optimieren, wobei sich Eigenschaften der metallischen und der ionischen (oxidischen) Materialbestandteile gezielt hervorheben und einstellen lassen. Mit Hilfe dieser Dünnschichtmaterialien können Werkzeuge und Bauteile mit einer Schutz- und Funktionsschicht beschichtet werden. Gegenüber den herkömmlichen Hartstoffschichten, wie Titannitrid, Chromnitrid, Titanaluminiumnitrid, zeichnen sich diese Dünnschichtmaterialien zusätzlich durch ihre Oxidations- und Hochtemperaturbeständigkeit sowie durch ihre deutlich geringere Oberflächenwechselwirkung mit Flüssigkeiten (Kühlschmiermittel) und Gegenkörpern ab.

Die Synthese von nanokristallinen, Silizium-basierten, metastabilen, multifunktionellen, oxidischen Hartstoffschichten kann beispielsweise durch alle PVD- und/oder PECVD-Verfahren (PVD: physical vapor deposition, PECVD: plasma enhanced chemical vapor deposition) bei entsprechender Wahl der Synthesebedingungen realisiert werden.

Die Erfindung wird im Folgenden anhand von Ausführungsbeispielen mit Figuren näher erläutert. Es zeigen
**Fig.1** eine graphische Darstellung der Einteilung von Hartstoffen in metallische, kovalente und ionische Hartstoffe,
**Fig.2a** **bis c** (nicht erfindungsgemäß) TEM-Aufnahmen der kubisch-flächenzentrierten (Ti,Si) (N,O)-Schicht. a) Hellfeldaufnahme, b) Dunkelfeldaufnahme, c) Beugungsbild sowie
**Fig.3a** **bis c** TEM-Aufnahmen der kubisch-flächenzentrierten (Ti,Si)(C,O)-Schicht. a) Hellfeldaufnahme, b) Dunkelfeldaufnahme, c) Beugungsbild.

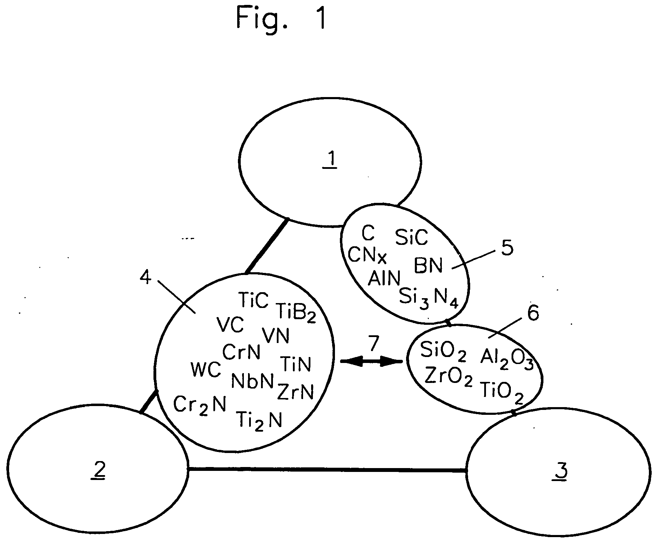

Eine graphische Darstellung der eingangs genannten Einteilung von Hartstoffen findet sich in **Fig.1****.** Grundsätzlich spielen bei Harstoffen drei Bindungsarten eine wesentliche Rolle, nämlich die kovalente Bindung **1,** metallische Bindung **2** und die ionische Bindung **3.** Die Bindungsarten spannen ein Dreieck auf, in das sich die drei eingangs genannten Hartstoffgruppen einordnen lassen. Entsprechend ihrer überwiegenden Bindungsart unterscheidet man eindeutig voneinander getrennt die Bereiche, in denen die metallische Hartstoffe **4,** kovalente Harststoffe **5** (Nichtoxidkeramiken) und ionische Hartstoffe **6** (Oxidkeramiken). Die im Rahmen der Erfindung angestrebte multifunktionale Hartstoffbeschichtung z.B. aus nanokristallinem, metastabilem, kubisch-flächenzentriertem, multifunktionellem Titansiliziumoxikarbid findet sich im Zwischenbereich **7** zwischen den metallischen und den ionischen Hartstoffen wieder.

In den folgenden Ausführungsbeispielen 1 (nicht erfindungsgemäß) und 2 werden beipielhaft zwei Materialsysteme beschrieben, nämlich nanokristallines, metastabiles, kubisch-flächenzentriertes, multifunktionelles Titansiliziumoxinitrid sowie Titansiliziumoxikarbid.

In beiden Ausführungsbeispielen werden die Hartstoffschichten durch Hochfrequenz-Magnetronzerstäuben eines Komposittargets, das die gewünschte atomare Zusammensetzung aufweist, in einem Argonplasma die entsprechenden Atome am Substratort zum Schichtwachstum hergestellt. In Ausführungsbeispiel 1 (nicht erfindungsgemäß) sind dies beispielsweise: 40 At% Titan, 40 At% Stickstoff, 5 At% Silizium und 5 At% Sauerstoff. Je nach Synthesebedingungen können sich folgende Konstitutionen ausbilden:
a) ein amorphes Titan-Silizium-Stickstoff-Sauerstoff-Netzwerk,
b) nanokristallines, kubisch-flächenzentriertes Titannitrid in einer amorphen Matrix, die aus Silizium und Sauerstoffatomen aufgebaut ist,
c) die gewünschte, einphasige, nanokristalline, metastabile, kubisch-flächenzentrierte (Ti,Si)(N,O)-Struktur und
d) ein Nanokomposit, bestehend aus zwei kristallinen Phasen: Titannitrid und Siliziumoxid.

Die unter (c) beschriebene einphasige, nanokristalline, metastabile, kubisch-flächenzentrierte (Ti,Si)(N,O)-Struktur ist vom Aufbau her vergleichbar mit der kubisch-flächenzentrierten Titannitrid-Struktur, nur dass gewichtet nach der atomaren Zusammensetzung auf den Titanplätzen auch Siliziumatome und auf den Stickstoffplätzen auch Sauerstoffatome sitzen. Die Konstitutionen (a) bis (d) können durch die Synthesebedingungen gezielt ausgebildet werden. Mit zunehmender Diffusionslänge der schichtbildenden Teilchen (hier: 40 At% Titan, 40 At% Stickstoff, 5 At% Silizium und 5 At% Sauerstoff) während des Syntheseprozesses können die Konstitutionen (a) bis (d) nacheinander eingestellt werden. Die Diffusionslänge der die Hartstoffbeschichtung bildenden Teilchen nimmt mit der Substrattemperatur und mit dem Energie- und Impulseintrags des Ionenbeschusses zu. Die in den Ausführungsbeispielen gewählten Synthesebedingungen ermöglichen die Ausbildung der Konstitution (c).

Die Hartstoffbeschichtungen wiesen beispielhaft einen arithmetischen Mittenrauhwert Rₐ von 3 nm bis 23 nm, eine Glättungstiefe Rp von 16 nm bis 200 nm, einen quadratischen Mittenrauhwert Rq von 6 nm bis 27 nm, eine Differenz Rₜ zwischen der höchsten Spitze zur tiefsten Riefe von 29 nm bis 170 nm sowie eine gemittelte Rauhtiefe R_{z(ISO)} von 20 nm bis 190 nm auf.

### Ausführungsbeispiel 1 (nicht erfindungsgemäß):

Synthesebeispiel von nanokristallinem, metastabilen, kubisch-flächenzentrierten (Ti,Si)(N,O)
Die Silizium- und Hartmetallsubstrate wurden für je 15 min in einem Aceton- und anschließend in einem Ultraschallbad mit Isopropanol gereinigt. Vor der eigentlichen Beschichtung wurden die Substrate plasmageätzt. Die Abscheidung der Hartstoffbeschichtung erfolgte mittels nicht reaktivem Hochfrequenz-Magnetronzerstäuben eines Ti-Si-N-O-Komposittargets (Zusammensetzung: TiN:SiO = 90:10, Durchmesser: 75 mm) bei einer Targetleistung von 300 W in einem reinen Argonplasma bei einen Druck von 0,15 Pa. Die Substrattemperatur betrug 600°C und der Substratbias -50 V.

Die nanokristalline kubisch-flächenzentrierte Struktur konnte durch Röntgenbeugungsuntersuchungen unter Verwendung von Kupfer Kα-Strahlung nachgewiesen werden (vgl. **Tabelle 1**). Aus dem Röntgenbeugungssignal bei 2θ = 60,91° mit einer Halbwertsbreite von 1,24° konnte unter Berücksichtigung der apparativen Verbreiterung ein Gitterparameter von 4,3 Å errechnet und mit Hilfe der Debye-Scherrer-Formel eine Kristallitgröße von ungefähr 9 nm abgeschätzt werden.

**Tabelle 1: Berechneter Netzebenenabstand, Gitterparameter und Kristallitgröße aus der Position und der Halbwertsbreite des Röntgenbeugungssignals für die kubisch-flächenzentrierte (Ti,Si)(N,O)-Schicht.**

| SiO Gehalt in Mol% | Signalposition in ° | Halbwertsbreite in ° | Netzebenenabstand in Å | Gitterparameter in Å | Kristallitgröße in nm |
|---|---|---|---|---|---|
| 10 | 60,91 | 1,24 | 1,52 | 4,30 | 9,28 |

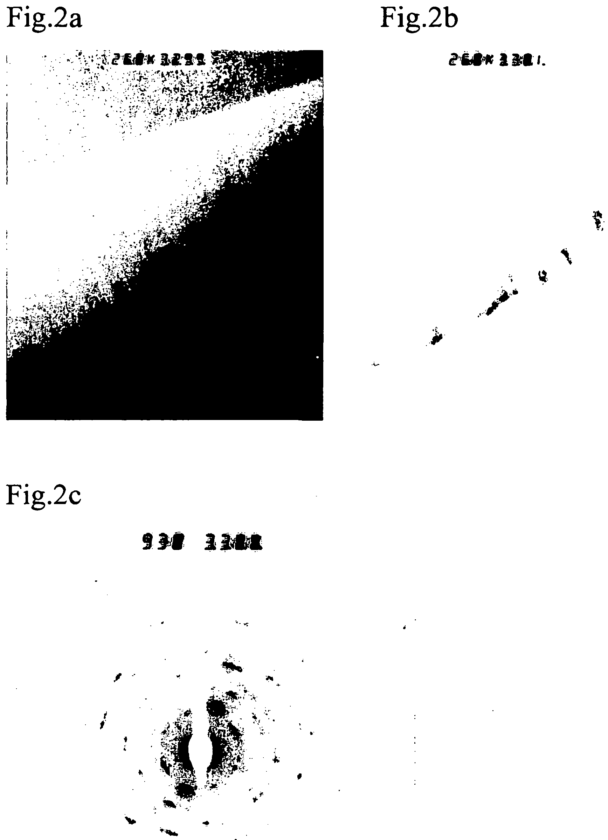

Ergänzend zu den Röntgenbeugungsanalysen auch Elektronenbeugungsuntersuchungen durchgeführt. **Fig.2a** zeigt eine Hellfeldaufnahme der (Ti_{0,9}, Si_{0,1}) (N_{0,9}, O_{0,1}) -Schicht, die mit 26000-facher Vergrößerung aufgenommen wurde. Der mittelgraue Bereich im oberen Teil des Bildes zeigt das Substrat. Zum schwarzen Bereich hin kann man die einzelnen Kristalle erkennen. Im unteren Bereich des Bildes ist kein Substrat mehr vorhanden. In diesem Grenzgebiet zeigen die dunklen Bereiche die Kristallite. Man kann auf dieser Aufnahme erkennen, dass die Kristalle senkrecht zur Substratoberfläche aufwachsen.

Die Dunkelfeldaufnahme, die die selbe Vergrößerung wie die Hellfeldaufnahme aufweist **(****Fig.2b****)** entsteht, wenn man einen Ausschnitt aus dem ersten Beugungsrings ablichtet. Hier sind die kristallinen Bereiche dunkel. Man sieht auf dem Bild die Kristalle, die die Reflexe im Beugungsbild verursacht haben. Auf der Aufnahme haben die Kristallite eine Länge zwischen 110 nm und 380 nm und eine Breite von 450 nm bis 750 nm.

In der Beugungsbildaufnahme **(****Fig.2c****)** erkennt man mehrere Radien, auf denen sich mehrere dunkle Punkte (Reflexe) befinden. Aus diesen Radien können die Netzebenabstände der Schicht bestimmt, der Kristalltyp festgelegt und der Gitterparameter berechnet werden. Als Kristallstruktur ergibt sich das kubisch-flächenzentrierte (Ti,Si)(N,O)-Gitter mit einem Gitterparameter von 4,3 Å.

Die nanokristalline, metastabile, multifunktionelle, kubischflächenzentriete (Ti,Si)(N,O)-Schicht zeigt herausragende mechanische Eigenschaften. Aufgrund der doppelten Mischkristallverfestigung des Gitters beträgt die Schichthärte beträgt 3100 HV und der reduzierte E-Modul 520 GPa. Die kritische Last des Versagens im Scratchtest liegt bei 38 N, was auf eine gute Haftfestigkeit hinweist. Die Haftfestigkeit kann durch eine Haftvermittlerschicht, z.B. aus Titannitrit TiN weiter gesteigert werden.

### Ausführungsbeispiel 2:

Synthesebeispiel von nanokristallinem, metastabilen, kubisch-flächenzentrierten (Ti,Si)(C,O)

Die Silizium- und Hartmetallsubstrate wurden für je 15 min in einem Aceton- und anschließend in einem Isopropanolultraschallbad gereinigt. Vor der eigentlichen Beschichtung wurden die Substrate Plasmageätzt. Die Schichtabscheidungung erfolgte mittels nicht reaktivem Hochfrequenz-Magnetronzerstäuben eines Ti-Si-C-O-Komposittargets (Zusammensetzung: TiC:SiO = 80:20, Durchmesser: 75 mm) bei einer Targetleistung von 300 W in einem reinen Argonplasma bei einen Druck von 0,15 Pa. Die Substrattemperatur betrug 600°C und der Substratbias - 50 V.

Die nanokristalline kubisch-flächenzentrierte Struktur konnte durch Röntgenbeugungsuntersuchungen unter Verwendung von Kupfer Kα-Strahlung nachgewiesen werden (vgl. **Tabelle 2).** Aus dem Röntgenbeugungssignal bei 2θ = 60,46° mit einer Halbwertsbreite von 2,65° konnte unter Berücksichtigung der apparativen Verbreiterung ein Gitterparameter von 4,33 Å errechnet und mit Hilfe der Debye-Scherrer-Formel eine Kristallitgröße von ungefähr 4 nm abgeschätzt werden.

**Tabelle 2: Berechneter Netzebenenabstand, Gitterparameter und Kristallitgröße aus der Position und der Halbwertsbreite des Röntgenbeugungssignals für die kubisch-flächenzentrierte (Ti,Si)(C,O)-Schicht.**

| SiO Gehalt in Mol% | Signalposition in ° | Halbwertsbreite in ° | Netzebenenabstand in Å | Gitterparameter in Å | Kristallitgröße in nm |
|---|---|---|---|---|---|
| 20 | 60,46 | 2,65 | 1,53 | 4,33 | 3,83 |

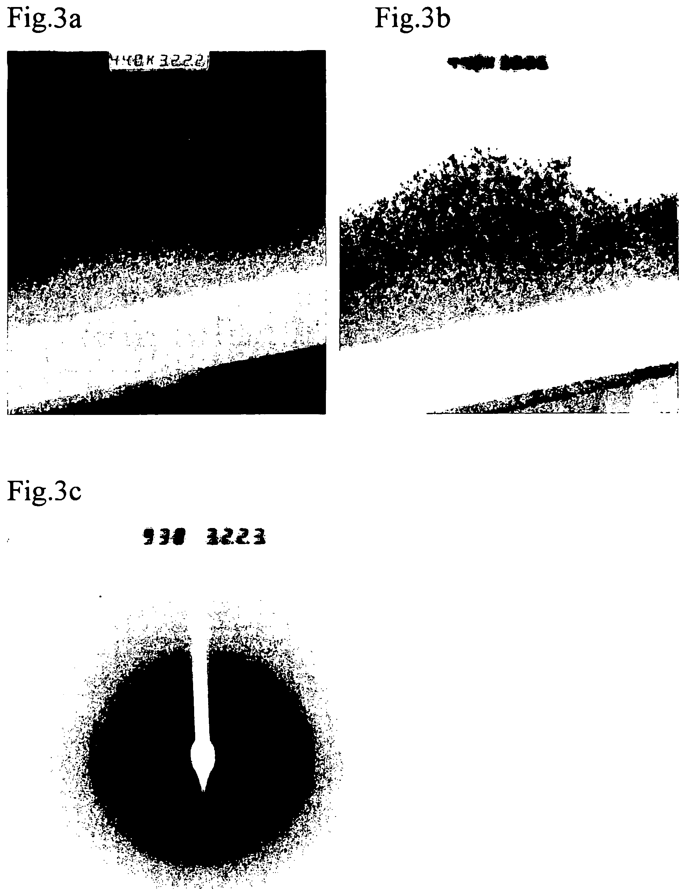

Ergänzend zu den Röntgenbeugungsanalysen auch Elektronenbeugungsuntersuchungen durchgeführt. **Fig.3a** zeigt eine Hellfeldaufnahme der (Ti_{0,8} Si_{0,2}) ( C_{0,8}, O_{0, 2}) -Schicht, die mit 44000-facher Vergrößerung aufgenommen wurde. Der mittelgraue Bereich im oberen Teil des Bildes zeigt das Substrat. Zum schwarzen Bereich hin kann man die einzelnen Kristalle erkennen. Im unteren Bereich des Bildes ist kein Substrat mehr vorhanden. In diesem Grenzgebiet zeigen die dunklen Bereiche die Kristallite. Man kann auf dieser Aufnahme erkennen, dass die Kristalle senkrecht zur Substratoberfläche aufwachsen.

Die Dunkelfeldaufnahme, die dieselbe Vergrößerung wie die Hellfeldaufnahme aufweist **(****Fig.3b****)** entsteht, wenn man einen Ausschnitt aus dem ersten Beugungsrings ablichtet. Hier sind die kristallinen Bereiche dunkel. Man sieht auf dem Bild die Kristalle, die die Reflexe im Beugungsbild verursacht haben. Auf der Aufnahme haben die Kristallite eine Länge zwischen 20 nm und 90 nm und eine Breite von ungefähr 350 nm.

In der Beugungsbildaufnahme **(****Fig.3c****)** erkennt man mehrere Beigungsringe. Aus den Radien können die Netzebenabstände der Schicht bestimmt, der Kristalltyp festgelegt und der Gitterparameter berechnet werden. Als Kristallstruktur ergibt sich das kubisch-flächenzentrierte (Ti,Si) (C,O)-Gitter mit einem Gitterparameter von 4,33 Ä.

Die nanokristalline, metastabile, multifunktionelle, kubischflächenzentriete (Ti,Si)(C,O)-Schicht zeigt herausragende mechanische Eigenschaften. Aufgrund der doppelten Mischkristallverfestigung des Gitters beträgt die Schichthärte beträgt 4200 HV und der reduzierte E-Modul 620 GPa. Somit handelt es sich um ein superhartes Material (Härte > 4000 HV). Die kritische Last des Versagens im Scratchtest liegt bei 23 N, was auf eine ausreichend gute Haftfestigkeit hinweist. Die Haftfestigkeit kann mit Hilfe einer Haftvermittlerschicht z.B. aus Titankarbid TiC weiter gesteigert werden.

### Bezugszeichenliste

- 1: kovalente Bindung
- 2: metallische Bindung
- 3: ionische Bindung
- 4: metallische Hartstoffe
- 5: kovalente Harststoffe
- 6: ionische Hartstoffe
- 7: Zwischenbereich

## Patentansprüche

1. Multifunktionelle Hartstoffbeschichtung auf einem Substrat, wobei die Hartstoffbeschichtung ein einphasiges und kristallines Gefüge aufweist und metastabile Mischkristalle aus zwei nicht miteinander lösbaren Hartstoffen als Materialbestandteile umfasst, wobei die Materialbestandteile einen metallischen Hartstoff **(4)** und einen ionischen Hartstoff **(6)** umfassen
wobei
die Materialbestandteile sich aus dem quasibinären System aus einem kubisch flächenzentrierten Hartstoff und einer Oxidkeramik bilden sowie
der kubisch flächenzentrierten Hartstoff ein Karbid eines Übergangsmetalls ist und die Oxidkeramik auf Al, Si oder Zr basiert.

2. Hartstoffbeschichtung nach Anspruch 1, wobei das Übergangsmetall Ti ist.

3. Hartstoffbeschichtung nach einem der vorgenannten Ansprüche, wobei die Hartstoffbeschichtung eine mittlere Korngröße zwischen 1 und 200 nm aufweist.

4. Hartstoffbeschichtung nach Anspruch 3, wobei das Substrat Temperiermittel aufweist.

5. Hartstoffbeschichtung nach Anspruch 3 oder 4, wobei die Temperiermittel einen temperierbaren Substratträger für das Substrat umfassen.

6. Hartstoffbeschichtung nach einem der vorgenannten Ansprüche, wobei das Substrat eine Oberfläche aus einem Metall, einem Hartmetall, einem Cermet, einer Legierung, aus Glas, einer Keramik oder aus einem Polymer aufweist.

7. Hartstoffbeschichtung nach einem der vorgenannten Ansprüche mit einem arithmetischen Mittenrauhwert Rₐ von 3 nm bis 23 nm, einer Glättungstiefe Rp von 16 nm bis 200 nm, einem quadratischen Mittenrauhwert R_{q} von 6 nm bis 27 nm, einer Differenz Rₜ zwischen der höchsten Spitze zur tiefsten Riefe von 29 nm bis 170 nm sowie einer gemittelten Rauhtiefe R_{z(ISO)} von 20 nm bis 190 nm.

8. Verfahren zur Herstellung einer multifunktionellen Hartstoffbeschichtung auf einem Substrat nach einem der vorgenannten Ansprüche, umfassend die folgenden Schritte:
a) Schleifen, Polieren und Reinigen eines Substrats,
b) Positionieren des Substrats in einer Prozesskammer mit einem Prozessgas einer PVD- und/oder PECVD-Anlage und Evakuierung der Prozesskammer, wobei in der Prozesskammer mindestens eine Kathode angeordnet ist, die mit dem Prozessgas alle Elemente für mindestens zwei nicht miteinander lösbaren Hartstoffen als Materialbestandteile für die Hartstoffbeschichtung umfasst,
c) simultane Überführung von Materialbestandteilen aus den Kathoden in ein Plasma sowie
d) simultanes Abscheiden der Materialbestandteile aus dem Plasma zu einer nanokristallinen Hartstoffbeschichtung mit einphasigem Gefüge auf dem Substrat,
wobei
e) die Materialbestandteile sich aus dem quasibinären System aus einem kubisch flächenzentrierten Hartstoff und einer Oxidkeramik bilden sowie der kubisch flächenzentrierten Hartstoff ein Karbid eines Übergangsmetalls ist und die Oxidkeramik auf Al, Si oder Zr basiert.

9. Verfahren nach Anspruch 8, wobei das Substrat gekühlt wird.

10. Verfahren nach Anspruch 8 oder 9, wobei sich eine mittlere Korngröße in der Hartstoffbeschichtung zwischen 1 und 200 nm einstellt.

## Claims

1. Multifunctional hard material coating on a substrate, wherein the hard material coating comprises a single-phase and crystalline structure and metastable mixed crystals made of two hard materials which are insoluble together as material components, wherein the material components comprise a metallic hard material **(4)** and an ionic hard material **(6)**,
**characterised in that**
the material components are formed from a quasi-binary system of a cubic face-centred hard material and an oxide ceramic, and
the cubic face-centred hard material is a carbide of a transition metal, and the oxide ceramic is based on Al, Si, or Zr.

2. Hard material coating according to claim 1, wherein the transition metal is Ti.

3. Hard material coating according to any one of the preceding claims, wherein the hard material coating exhibits a mean grain size of between 1 and 200 nm.

4. Hard material coating according to claim 3, wherein the substrate comprises tempering means.

5. Hard material coating according claim 3 or 4, wherein the tempering means comprise a temperable substrate carrier for the substrate.

6. Hard material coating according to any one of the preceding claims, wherein the substrate comprises a surface made of a metal, a hard metal, a cermet, an alloy, glass, a ceramic, or a polymer.

7. Hard material coating according to any one of the preceding claims, with an arithmetic mean roughness index Rₐ of 3 nm to 23 nm, a smoothing depth Rₚ of 16 nm to 200 nm, a quadratic mean roughness index R_{q} of 6 nm to 27 nm, a difference Rₜ between the highest peak to the lowest groove of 29 nm to 170 nm, and an averaged roughness depth R_{z(ISO)} of 20 nm to 190 nm.

8. Method for producing a multifunctional hard material coating on a substrate according to any one of the preceding claims, comprising the following steps:
a) grinding, polishing, and cleaning of a substrate,
b) positioning of the substrate in a process chamber with a process gas of a PVD and/or PECVD system, and evacuation of the process chamber, wherein at least one cathode is arranged in the process chamber, which, with the process gas, comprises all the elements for at least two hard materials which are insoluble together, as material components for the hard material coating,
c) simultaneous conversion of material components from the cathodes into a plasma, and
d) simultaneous separation of the material components out of the plasma to a nanocrystalline hard material coating with single-phase structure on the substrate,
wherein
e) the material components are formed from the quasi-binary system from a cubic face-centred hard material and an oxide ceramic, and the cubic face-centred hard material is a carbide of a transition metal and the oxide ceramic is based on Al, Si, or Zr.

9. Method according to claim 8, wherein the substrate is cooled.

10. Method according to claim 8 or 9, wherein a mean grain size in the hard material coating of between 1 and 200 nm is adjusted.

## Revendications

1. Revêtement multifonctionnel en un matériau dur d'un substrat, ce revêtement en un matériau dur ayant une structure monophasée et cristalline et renfermant en tant que composants du matériau des solutions solides métastables de deux matériaux durs non solubles entre eux, les composants du matériau renfermant un matériau dur métallique (4) et un matériau dur ionique (6), les composants du matériau se formant dans un système quasi binaire comprenant un matériau dur cubique à faces centrées et une céramique oxydée, et
le matériau dur cubique à faces centrées étant un carbure d'un métal de transition et la céramique oxydée étant à base de Al, Si ou Zr.

2. Revêtement en un matériau dur conforme à la revendication 1, dans lequel le métal de transition est Ti.

3. Revêtement en un matériau dur conforme à l'une des revendications précédentes,
dans lequel le revêtement en un matériau dur présente une granulométrie moyenne comprise entre 1 et 200 nm.

4. Revêtement en un matériau dur conforme à la revendication 3, dans lequel le substrat comprend un agent d'équilibrage de la température.

5. Revêtement en un matériau dur conforme à la revendication 3 ou 4, dans lequel l'agent d'équilibrage de la température comprend un support de substrat pouvant permettre l'équilibrage en température du substrat.

6. Revêtement en un matériau dur conforme à l'une des revendications précédentes,
dans lequel le substrat comporte une surface en un métal, un métal dur, un Cermet, un alliage, en verre, en une céramique ou en un polymère.

7. Revêtement en un matériau dur conforme à l'une des revendications précédentes,
ayant une rugosité moyenne arithmétique Rₐ de 3 nm à 23 nm, une profondeur de lissage Rp de 16 nm à 200 nm, une rugosité moyenne quadratique R_{q} de 6 nm à 27 nm, une différence Rₜ entre la pointe la plus haute et la rainure la plus profonde de 29 nm à 170 nm et une profondeur de rugosité moyennée de 20 nm à 190 nm.

8. Procédé d'obtention d'un revêtement en un matériau dur multi fonctionnel sur un substrat, conforme à l'une des revendications précédentes, comprenant les étapes suivantes consistant à :
a) poncer, polir et nettoyer un substrat,
b) positionner le substrat dans une chambre de traitement comprenant un gaz de traitement, une installation PVD et/ou PECVD et une mise sous vide de la chambre de traitement, dans cette chambre de traitement étant montée au moins une cathode qui renferme avec le gaz de traitement tous les éléments d'obtention d'au moins deux matériaux durs non solubles entre eux constituant les composants du matériau du revêtement en un matériau dur,
c) transférer simultanément les composants du matériau de la cathode dans un plasma, et
d) séparer simultanément les composants du matériau du plasma pour obtenir sur le substrat un revêtement en un matériau dur nanocristallin ayant une structure monophasée,
e) les composants du matériau se formant dans un système quasi binaire comprenant un matériau dur cubique à faces centrées et une céramique oxydée, et le matériau dur cubique à faces centrées étant un carbure d'un métal de transition et la céramique oxydée étant à base d'Al de Si ou de Zr.

9. Procédé conforme à la revendication 8,
selon lequel le substrat est refroidi.

10. Procédé conforme à la revendication 8 ou 9,
selon lequel une granulométrie moyenne entre 1 et 200 nm se règle dans le revêtement en un matériau dur.
